# EUROPEAN PATENT APPLICATION

(11) **EP 4 712 274 A1**
(43) Date of publication of application: **18.03.2026**
(21) Application number: 25202318.9
(22) Date of filing: 15.09.2025
(51) Int. Cl.: H01R 24/50, H01R 12/57

(54) **INVERTED COAXIAL SUBSTRATE CONNECTOR**

(30) Priority: 16.09.2024 US 202463695221 P; 21.08.2025 US 202519306348
(71) Applicant: TE Connectivity Solutions GmbH, 8200 Schaffhausen (CH)
(72) Inventor: Blasick, Francis John, Middletown, 17057 (US); Champion, Bruce Allen, Middletown, 17057 (US); Morris, Andrew, Middletown, 17057 (US); Kratzer, Jonathan T., Middletown, 17057 (US)
(74) Representative: Johnstone, Edward Ian

(57) **Abstract**

An electrical assembly (2) having a substrate (52) and an RF connector (10). The substrate (52) has an opening (50) which extends from a first surface (54) of the substrate to a second surface (56) of the substrate. The RF connector (10) includes a conductive shell (12), a dielectric insert (14) and a contact (16). The conductive shell (12) has a mating connector receiving portion (18) and a substrate mounting portion (22). The substrate mounting portion (22) has a substrate mounting surface (24) which engages the first surface (54) of the substrate (52). The mating connector receiving portion (18) extends from the substrate mounting surface (24) through the opening (50) to the second surface (56) of the substrate (52). The contact (16) has a surface mount portion (37) positioned proximate the substrate mounting surface (24) of the substrate mounting portion (22). The surface mount portion (37) is mechanically and electrically engaged with a contact pad (62) on the first surface (54) of the substrate (52).

## Description

The invention relates generally to an inverted coaxial connector which terminates to one side of a substrate or printed circuit board (PCB), but has a mating interface that is accessible on an opposite side of the substrate or PCB via an opening in the substrate.

In various electrical assemblies or systems components on a main card backplane must be electrically connected to components on a mezzanine card. As the electrical assemblies and the components become more complicated and numerous, space on the surface of the main card backplane and the mezzanine card to house the components is difficult to find. In order to allow for more components, the components may terminate to both sides of the mezzanine card. While this provides more surface area for the components, the connections between the components on a main card backplane and the components on a mezzanine card is complicated due to limited space. In particular, when high signal frequencies are required, the connections must maintain the signal integrity while occupying as little space as possible.

It would, therefore, be beneficial to provide an inverted coaxial printed circuit board (PCB) connector which terminates to one side of the PCB, but has a mating interface that is accessible on an opposite side of the PCB via a through-hole in the PCB, thereby allowing for proper signal integrity while occupying minimal board space and valuable space above and below the mezzanine card.

The solution is provided by an RF connector having a conductive shell, a dielectric insert and a contact. The conductive shell has a mating connector receiving portion and a substrate mounting portion. The substrate mounting portion has a substrate mounting surface, the mating connector receiving portion extends from the substrate mounting surface. The contact has a surface mount portion positioned proximate the substrate mounting surface of the substrate mounting portion.

The invention will now be described by way of example with reference to the accompanying drawings in which:
FIG. 1 is a perspective front view of a first illustrative embodiment of right angle RF connector according to the present invention mounted on a substrate.
FIG. 2 is a perspective back view of the connector and substrate of FIG. 1.
FIG. 3 is a side view of the connector and substrate of FIG. 1.
FIG. 4 is a top view of the connector and substrate of FIG. 1.
FIG. 5 is a cross-sectional view of the connector and substrate taken along line 5-5 of FIG. 3.
Fig. 6 is a perspective view of the RF connector similar to the RF connector of FIG. 1, with a cover mounting member exploded therefrom.
FIG. 7 is a cross-sectional view of the connector taken along line 7-7 of FIG. 6.
FIG. 8 is a perspective front view a mating RF connector mated to the connector of FIG. 1.
FIG. 9 is a side view of the connector, substrate and mating connector of FIG. 8.
FIG. 10 is a cross-sectional view of the connector, substrate and mating connector taken along line 10-10 of FIG. 8.
FIG. 11 is a diagrammatic view of a system in which the right angle RF connector of the present invention is used.

An embodiment is directed to an RF connector having a conductive shell, a dielectric insert and a contact. The conductive shell has a mating connector receiving portion and a substrate mounting portion. The substrate mounting portion has a substrate mounting surface, the mating connector receiving portion extends from the substrate mounting surface. The contact has a surface mount portion positioned proximate the substrate mounting surface of the substrate mounting portion.

An embodiment is directed to an electrical assembly having a substrate and an RF connector. The substrate has an opening which extends from a first surface of the substrate to a second surface of the substrate. The RF connector includes a conductive shell, a dielectric insert and a contact. The conductive shell has a mating connector receiving portion and a substrate mounting portion. The substrate mounting portion has a substrate mounting surface which engages the first surface of the substrate. The mating connector receiving portion extends from the substrate mounting surface through the opening to the second surface of the substrate. The contact has a surface mount portion positioned proximate the substrate mounting surface of the substrate mounting portion. The surface mount portion is mechanically and electrically engaged with a contact pad on the first surface of the substrate. An electrical connection can be made between a device on the second side of the substrate and a component mounted on the first side through the RF connector

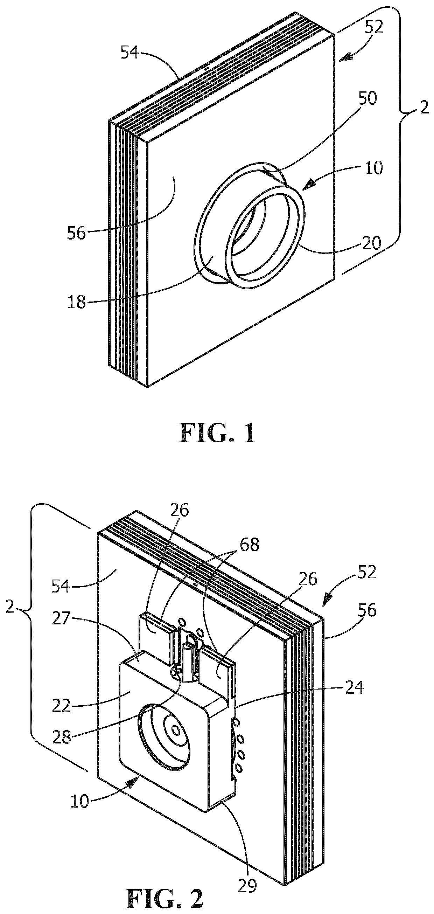

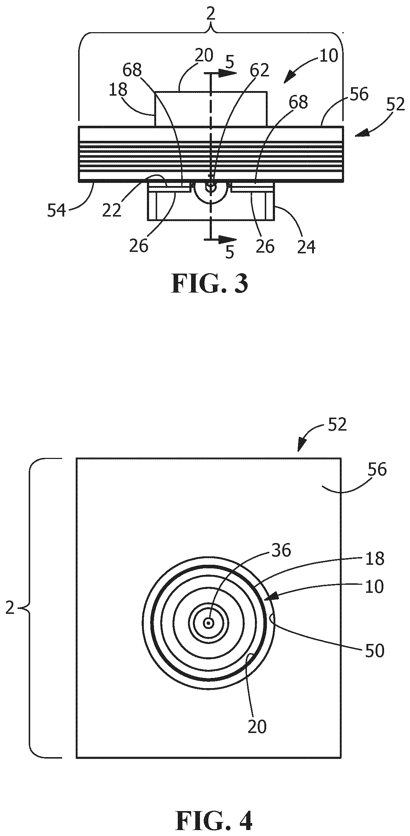

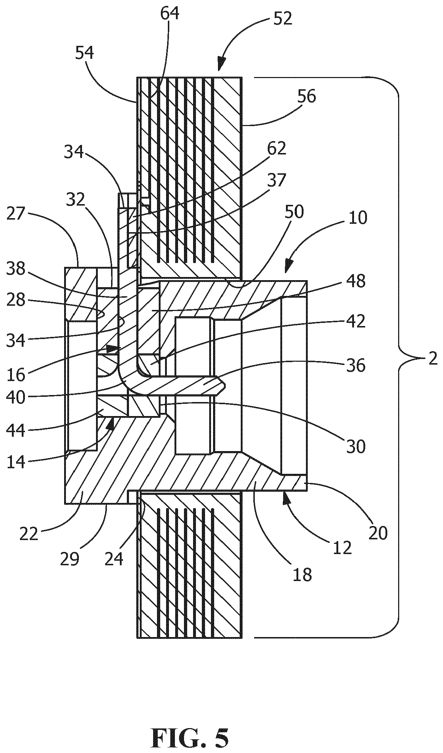

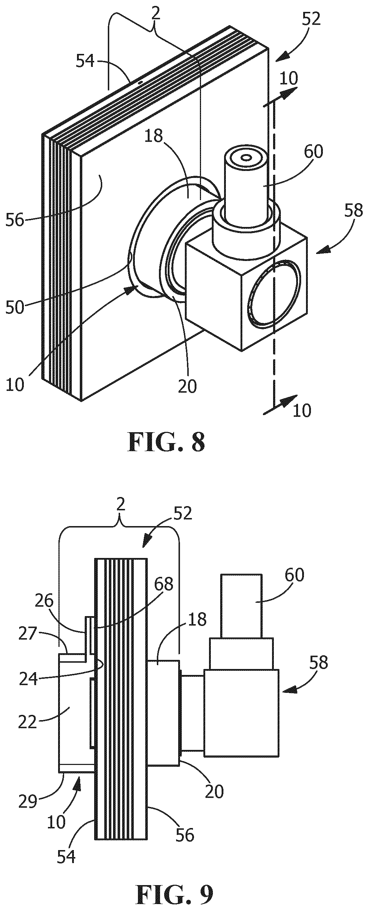

As shown in FIGS. 1 through 10, a right angle RF (radio frequency) connector 10 is mounted in an opening 50 of a substrate or printed circuit board 52 to form an electrical assembly 2. As shown in FIGS. 5, 6, 7 and 10, the connector 10 includes a conductive or metal shell 12, a dielectric insert assembly 14, and a pin or contact 16.

In the illustrative embodiment shown, the metal shell 12 is formed in one piece and is made of metal, but other configurations and conductive material which provides the desired shielding may be used. The shell 12 has a mating connector receiving portion 18 with a mating connector receiving surface 20 and a substrate mounting portion 22 with substrate mounting surface 24. The mating connector receiving surface 20 extends in a plane which is essentially parallel to a plane in which the substrate mounting surface 24 extends. The mating connector receiving portion 18 extends from the substrate mounting surface 24 of the substrate mounting portion 22.

PCB ground or legs 26 extend from the substrate mounting portion 22 of the shell 12. In the illustrative embodiment shown, the PCB ground or legs 26 are integrally formed with the shell 12, but other configurations may be used which provide an electrical connection between the PCB ground or legs 26 and the shell 12. The PCB ground or legs 26 are positioned proximate the substrate mounting surface 24 of the substrate mounting portion 22.

A dielectric receiving passage 28 is provided in the substrate mounting portion 22. The dielectric receiving passage 28 extends from a first surface 27 of the substrate mounting portion 22 toward a second surface 29 of the substrate mounting portion 22. The dielectric receiving passage 28 opens to the mating connector receiving portion 18. The dielectric receiving passage 28 has a circular cross section with a constant radius.

The dielectric insert assembly 14 may be formed by different methods, including molding or an additive process, such as 3D printing. The dielectric insert assembly 14 is made of an insulating material that does not conduct electricity. The dielectric insert 14 is configured to be positioned in the dielectric receiving passage 28. The dielectric insert assembly 14 has a circular cross section with a constant radius which extends from a first surface 30 proximate the mating connector receiving portion 18 to a second surface 32 in the substrate mounting portion 22. The first surface 30 extends in a plane which is essentially perpendicular to a plane in which the second surface 32 extends. The radius of the dielectric insert assembly 14 is approximately equal to the radius of the dielectric receiving passage 28. The dielectric insert assembly 14 has a contact receiving passage 34 which extends through the dielectric insert assembly 14 from the first surface 30 to the second surface 32.

The contact 16 is made of conductive material and is positioned in the contact receiving passage 34. The contact 16 has a circular cross section with a constant radius. The radius of the contact 16 is approximately equal to the radius of the contact receiving passage 34. The contact 16 has a first straight portion 36 which extends into the mating connector receiving portion 18, a second straight portion 38 which extends into the substrate mounting portion 22, and an arcuate portion 40 which is positioned in the contact receiving passage 34 and which extends between the first straight portion 36 and the second straight portion 38. The second straight portion 38 has a surface mount portion 37 proximate a free end 39 thereof. The surface mount portion 37 is positioned proximate the substrate mounting surface 24 of the substrate mounting portion 22.

In the illustrative embodiment shown in FIGS. 1 through 5 and 8 through 10, the dielectric insert assembly 14 is made of three components. In other embodiments the dielectric insert assembly 14 may have a different configuration or number of components.

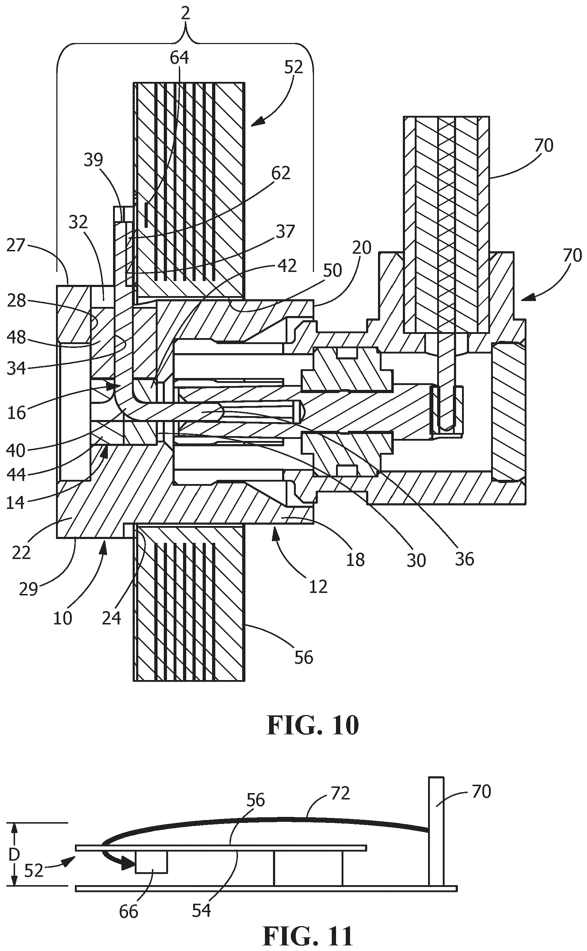

As shown in FIGS. 5 and 10 a first component 42 has a circular cross section and extends around the first straight portion 36 of the contact 16. The second component 44 is positioned to the side of the contact 16 and to the side of the first component, as viewed in FIGS. 5, 7 and 10. The second component 44 has a circular cross section. In the illustrative embodiment shown, the second component 44 has the same configuration as the first component 42. However, the second component 44 may have other configurations. A third component 48 is positioned proximate the first component 42 and the second component 44. The third component 48 extends 360 degrees around the second straight portion 38 of the contact 16. The dielectric strengths of the first component 42, the second component 44 and the third component 48 may be the same or may be varied to provide the desired performance.

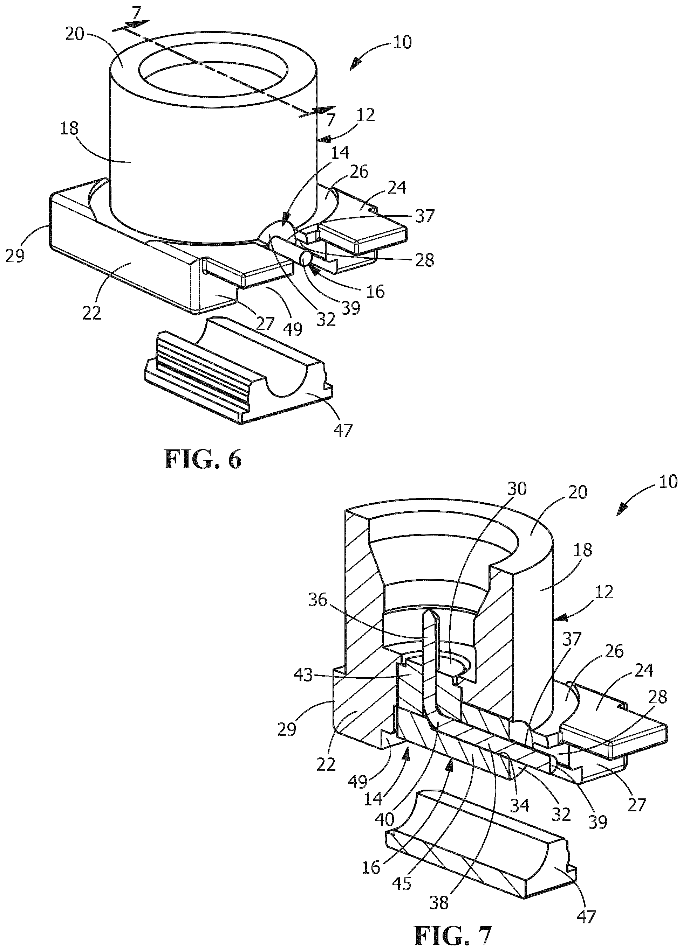

FIGS. 6 and 7 illustrate a slightly different embodiment. As shown in FIG. 7, the dielectric insert assembly 14 is made of two components. A first component 43 has a circular cross section and extends around the first straight portion 36 of the contact 16. A second component 45 is positioned proximate the first component 43. The second component 45 extends 360 degrees around the second straight portion 38 of the contact 16. The dielectric strengths of the first component 43 and the second component 45 may be the same or may be varied to provide the desired performance. A cover mounting member 47 is also provided in the embodiment shown in FIGS. 6 and 7. The cover mounting member 47 is configured to be positioned and maintained in the cavity 49 of the shell 12. The cover mounting member 47 cooperates with the second component 45 to properly position and maintain the second component 45 and the dielectric insert assembly 14 in the shell 12.

In use, the connector 10 is inserted into the opening 50 of the substrate 52 to form the electrical assembly 2. In this position, the mating connector receiving portion 18 extends through the opening 50 from a first surface 54 of the substrate 52 to beyond a second surface 56 of the substrate 52. As the mating connector receiving portion 18 and the mating connector receiving surface 20 extends beyond the second surface 56, the mating connector receiving portion 18 is positioned to receive a mating connector 58 which terminates a cable 60 therein. The cable 60 may be a coaxial cable comprising a central conductor surrounded by a concentric conducting shield.

As shown in FIGS. 2, 3, 5, 9 and 11, the substrate mounting portion 22 is positioned proximate the first surface 54 of the substrate 52. As the substrate mounting surface 24 and the substrate mounting portion 22 are dimensioned to be larger than the opening 50 in the substrate 52, the substrate mounting surface 24 and the substrate mounting portion 22 are prevented from moving beyond the first surface 54.

When the connector 10 is properly inserted into the opening 50 of the substrate 52, the surface mount portion 37 of the contact 16 is provided in mechanical and electrical engagement with a signal contact pad 62 provided on the first surface 54 of the substate 52. The surface mount portion 37 is retained in mechanical and electrical engagement with the signal contact pad 62 by solder or other known methods. The signal contact pad 62 is provided in electrical engagement with one or more traces 64 of the substrate. The one or more traces 64 are in electrical engagement with a chip or other device, as represented by 66 in FIG. 11, located on the first surface 54.

In addition, the PCB ground or legs 26 are provided in mechanical and electrical engagement with one or more grounding pads 68 provided on the first surface 54 of the substate 52. The PCB ground or legs 26 are retained in mechanical and electrical engagement with the grounding contact pad 68 by solder or other known methods.

By having a connector 10 which extends through an opening 50 in a substrate 52, a main board or other component or device 70 can be electrically connected to a component or device 66 on a first side 54 of a substrate 52 which is accessible through the RF connector 10, as represented by area 72 in FIG. 11. This is beneficial when the distance D does not allow the device 66 to be positioned on the second side 56 of the substrate 52 because of space limitations. The use of the connector 10 also allows more devices to be positioned on the first side 54, thereby allowing for a higher density of the devices in a limited or confined space.

## Claims

1. An RF connector (10) comprising:
a conductive shell (12);
a dielectric insert (14);
a contact (16);
the conductive shell (12) having a mating connector receiving portion (18) and a substrate mounting portion (22), the substrate mounting portion (22) having a substrate mounting surface (24), the mating connector receiving portion (18) extending from the substrate mounting surface (24);
the contact (16) having a surface mount portion (37) positioned proximate the substrate mounting surface (24) of the substrate mounting portion (22).

2. The RF connector (10) as recited in claim 1, wherein the conductive shell (12) is formed in at least one piece and is made of metal.

3. The RF connector (10) as recited in claim 1 or claim 2, wherein the mating connector receiving portion (18) has a mating connector receiving surface (20), the mating connector receiving surface (20) extends in a plane which is essentially parallel to a plane in which the substrate mounting surface (24) extends.

4. The RF connector (10) as recited in any preceding claim, wherein a PCB ground or legs (26) extend from the substrate mounting portion (22) proximate the substrate mounting surface (24).

5. The RF connector (10) as recited in claim 4, wherein the PCB ground or legs (26) are integrally formed with the conductive shell (12).

6. The RF connector (10) as recited in any preceding claim, wherein a dielectric receiving passage (28) is provided in the substrate mounting portion (22), the dielectric receiving passage (28) opens to the mating connector receiving portion (18).

7. The RF connector (10) as recited in claim 6, wherein the dielectric insert (14) is configured to be positioned in the dielectric receiving passage (28) and extends from a first surface (30) proximate the mating connector receiving portion (18) to a second surface (32) in the substrate mounting portion (22), the first surface (30) extends in a plane which is essentially perpendicular to a plane in which the second surface (32) extends.

8. The RF connector (10) as recited in any preceding claim, wherein the contact (16) has a first straight portion (36) which extends into the mating connector receiving portion (18), a second straight portion (38) which extends into the substrate mounting portion (22), and an arcuate portion (40) which extends between the first straight portion (36) and the second straight portion (38), the surface mount portion (37) positioned on the second straight portion (38).

9. The RF connector (10) as recited in claim 8, wherein the dielectric insert (14) is made of three components.

10. The RF connector (10) as recited in claim 9, wherein a first component (42) extends around the first straight portion (36) of the contact (16), a second component (44) is positioned to the side of the contact (16) and to the side of the first component (42), and a third component (48) is positioned proximate the first component (42) and the second component (44), the third component (48) extends 360 degrees around the second straight portion (38) of the contact (16).

11. An electrical assembly (2) comprising:
a substrate (52) with an opening (50) extending from a first surface (54) of the substrate to a second surface (56) of the substrate;
an RF connector (10) comprising:
a conductive shell (12);
a dielectric insert (14);
a contact (16);
the conductive shell (12) having a mating connector receiving portion (18) and a substrate mounting portion (22), the substrate mounting portion (22) having a substrate mounting surface (24) which engages the first surface (54) of the substrate (52), the mating connector receiving portion (18) extending from the substrate mounting surface (24) through the opening (50) to the second surface (56) of the substrate (52);
the contact (16) having a surface mount portion (37) positioned proximate the substrate mounting surface (24) of the substrate mounting portion (22), the surface mount portion (37) being mechanically and electrically engaged with a contact pad (62) on the first surface (54) of the substrate (52);
wherein an electrical connection can be made between a device on the second side (56) of the substrate (52) and a component mounted on the first side (54) through the RF connector (10).

12. The electrical assembly (2) as recited in claim 11, wherein the conductive shell (12) of the RF connector (10) is formed in at least one piece and is made of metal.

13. The electrical assembly (2) as recited in claim 11 or claim 12, wherein the mating connector receiving portion (18) has a mating connector receiving surface (20), the mating connector receiving surface (20) extends in a plane which is essentially parallel to a plane in which the substrate mounting surface (24) extends.

14. The electrical assembly (2) as recited in any of claims 11 to 13, wherein a PCB ground or legs 26 extend from the substrate mounting portion (22) proximate the substrate mounting surface (24), the PCB ground or legs 26 are mechanically and electrically engaged with one or more grounding pads (68) on the first surface (54) of the substrate (52).

15. The electrical assembly (2) as recited in claim 14, wherein the PCB ground or legs (26) are integrally formed with the conductive shell (12).
